# EUROPEAN PATENT SPECIFICATION

(11) **EP 2 106 025 B1**
(45) Date of publication and mention of the grant of the patent: **02.04.2014**
(21) Application number: 09460013.7
(22) Date of filing: 17.03.2009
(51) Int. Cl.: H03K 3/57

(54) **The method for shaping of high voltage pulse in a generator module and high voltage generator setup**
Verfahren zum Formen eines Hochspannungsimpulses in einem Generatormodul und Hochspannungsgenerator-Einrichtung
Procédé de formation d'une impulsion haute tension dans un module générateur et configuration du générateur haute tension

(30) Priority: 27.03.2008 PL 38479508
(43) Date of publication of application: 30.09.2009
(73) Proprietor: Zachodniopomorski Uniwersytet Technologiczny w Szczecinie, 70-310 Szczecin (PL)
(72) Inventor: Kalisiak, Stanislaw, 71-312 Szczecin (PL); Holub, Marcin, 71-479 Szczecin (PL); Bojanski, Ludwik, 70-454 Szczecin (PL)
(74) Representative: Zawadzka, Renata

(56) References cited:
- EP-A- 0 094 765
- FR-A- 2 495 853
- US-A- 3 746 881
- US-A- 5 105 097
- US-A- 5 561 597
- US-B1- 7 307 362

## Description

The invention relates to high voltage generator setup aimed at, between other applications, plasma generation in high power reactor modules.

In existing high voltage pulse generators based on Marx topology, as described in German Patent Publication DE455933, the output voltage is equal to maximally the multiplication of number of modules used for construction while maximum voltage value of singular module is limited to maximum allowable switching element blocking voltage. The Fitch topology, as described in United States Patents US3366799 and US3746881, US7209373 in conjunction with Marx topology allows to double the maximal voltage value while maintaining the same number of used modules. Recent developments of the solutions described above refer to simple replacement of switching elements as spark-gaps and thyratrons by semiconductor, solid state power switches as described in "Solid-state Marx Bank Modulator For the Next Linear Collider", proceedings of EPAC 2004, Lucerne, Switzerland. In addition saturable magnetic cores can be used as switches as described in US5105097. Another possibility to double the voltage of the supply system in pulsed operation is described in US4409492, FR2495853 where shock excited pulse transformer is used in order to recharge initially charged capacitors. Still the voltage multiplication factor of a single module is equal to 2.

High voltage generator setup, according to present invention, constructed of at least one module that includes plurality of capacitors, inductors and switching elements is characterized by the fact, that the module includes three capacitors. The first input of the module is connected to the first terminal of the first capacitor, on the other hand the second input of the module is connected to the anode of the first diode which cathode is connected to the second terminal of the first capacitor and the firs terminal of the second capacitor and the first terminal of the second inductor. The second output of the module consists of the second terminal of the second inductor connected to the first terminal of the bi-directional switch and simultaneously cathode of the third diode and the first terminal of the third capacitor. This connection point also creates the second output of the module. The second terminal of the third capacitor is connected simultaneously with the first terminal of the third inductor and the anode of the second diode and creating the first output of the module. The second terminal of the third inductor is connected to the anode of the third diode and the second terminal of the bi-directional switch and the second terminal of the second capacitor. Cathode of the second diode is connected with the first terminal of the first inductor, the second terminal of the first inductor is connected to the first terminal of the of the first capacitor. The secondary side of the transformer is connected between the first and second input of the module where the primary side is put within a pulse shaping circuitry. Advantageously first output of the module is connected to the first terminal of the non-linear choke, which second terminal is connected to the first terminal of the load, and the second terminal of the load is connected to the grounded terminal where also one of the terminals of the secondary transformer side is connected as well as the second terminal of the first inductor and the first terminal of the of the first capacitor. As a power switch in the described setup every switching element can be used, preferably a transistor with anti-parallel diode connected in parallel with the switch with reversed conduction direction. It is profitable to magnetically couple the second and third inductor. In the generator setup as invented the second and third capacitor are connected in parallel, and their voltage polarity is reversed with respect to the first capacitor. In the moment of switch operation two processes are initiated. The first process consists of resonant recharge of the second and third capacitor through the second and third inductor, profitably magnetically coupled as the voltage change dynamics across the second and third capacitor will be equal. The second process states the addition of voltages across all three capacitors of the module. The effect of voltage addition in the moment of switch operation results in momentary negative voltage with the initial value of a single capacitor voltage. The maximal output voltage value is reached after the entire recharge period of the second and third capacitor that is after the half-wave oscillation period and it reaches the value of tripled initial voltage value of a single capacitor in the module.

It is profitable to implement a multi-module construction with consecutive modules connected in series where the first output of the previous module is connected to the first input of the following module, and the second output of the previous module is connected to the second input of the following module. It allows output voltage multiplication equal to the number of maximum voltage across a single module multiplied with the overall number of consecutive modules.

Triple voltage multiplication across a single module allows higher overall voltage output when compared to other present solutions, which in practice enables lowering of the number of necessary modules. Initial negative voltage slope significantly lowers the time integral of the half-wave voltage oscillation period which enables output magnetic compression circuit magnetic core volume reduction.

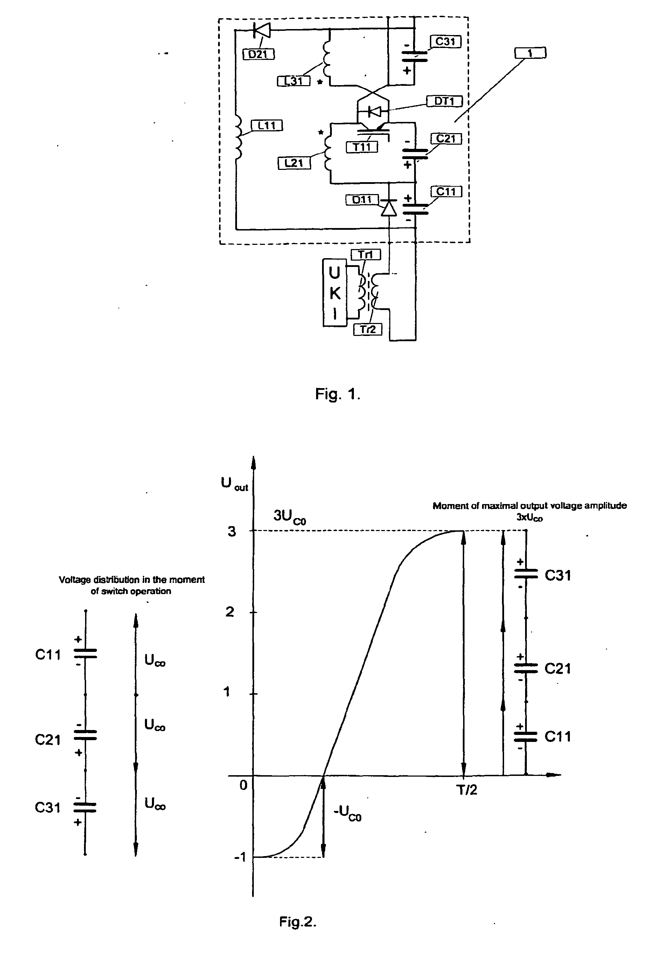

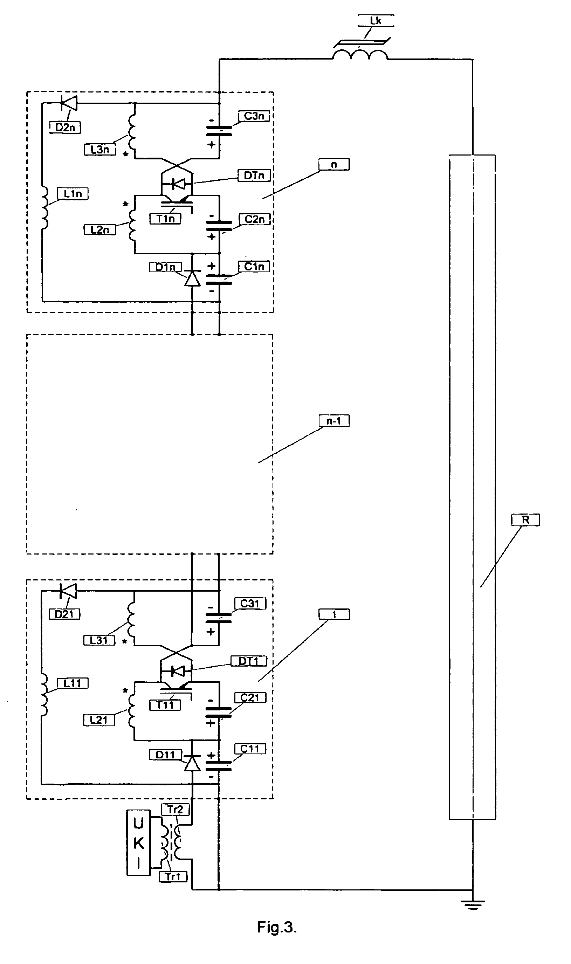

Invented means of voltage pulse shaping as well as invented generator setup are depicted in examples and on Figures, where Figure 1 depicts pictorial diagram of a single module, Figure 2 gives a graphical representation of the output voltage pulse after bi-directional power switch operation up to the moment when maximum output voltage amplitude is reached.

### Example 1:

Setup includes single module (1), which includes three capacitors. The first input (1) is connected to the first terminal of the first capacitor (C11), on the other hand the second input of the module (1) is connected to the anode of the first diode (D11), which cathode is connected to the second terminal of the first capacitor (C11) and the first terminal of the second capacitor (C21) and the first terminal of the second inductor (L21). The second terminal of the second inductor (L21) is connected to the collector terminal of the IGBT switch (T11) with additional diode (DT1) connected anti-parallel to the power switch (T11). Simultaneously it is connected to the cathode of the of the third diode (DT1) and the first terminal of the third capacitor (C31). In this way the second output of the module (1) is created. The second terminal of the third capacitor (C31) is connected simultaneously with the first terminal of the third inductor (L31) and the anode of the second diode (D21) and states the first output of the module (1). The second terminal of the third inductor (L31) is connected to the anode of the third diode (DT1) and the emitter terminal of the IGBT switch (T11) and the second terminal of the second capacitor (C21), cathode of the second diode (D21) is connected with the first terminal of the first inductor (L11), the second terminal of the first inductor (L11) is connected to the first terminal of the of the first capacitor (C11). Between the first and second input of the module (1) the secondary side of the transformer (Tr2) is connected which primary side (Tr1) is put within a pulse shaping circuitry (UKI). The shape forming circuitry (UKI) is shaping the power supply pulses of the module (1) with the means of supplying its primary side (Tr1). First output of the module (1) is connected to the first terminal of the non-linear choke (Lk), which second terminal is connected to the first terminal of the load (R). The second terminal of the load (R) is connected to the grounded terminal where also one of the terminals of the secondary transformer side (Tr2) is connected as well as the second terminal of the inductor (L11).

Turning-on of the power switch (T11) through magnetically coupled inductors (L21) and (L31) to parallel connected capacitors (C21) and (C31) begins the process of resonant recharge that changes the polarity of the voltage across these capacitors and simultaneously connects all three capacitors (C11, C21, C31) in series. In the moment of switch (T11) operation the output voltage of module (1) has a momentary negative value of a single capacitor voltage, while after the half-wave oscillation period it reaches the value of tripled initial voltage value of a single capacitor in the module.

### Example 2:

Setup as described in example 1 however made of three modules. The first output of the first module (1) is connected to the first input of the second module (1), while the second output of the first module (1) is connected to the second input of the second module (1). The first output of the second module (1) is connected to the first input of the third module (1), while the second output of the second module (1) is connected to the second input of the third module (1). The first output of the third module (1) is connected to the first terminal of the non-linear choke (Lk), which second terminal is connected to the first terminal of the load (R). The second terminal of the load (R) is connected to the grounded terminal where also one of the terminals of the secondary transformer side (Tr2) is connected as well as the second terminal of the inductor (L11) of the first module (1).

## Claims

1. High voltage pulse generator setup, constructed of at least one module, including capacitors, inductors and a bi-directional switch, **characterized in that** the module (1) includes three capacitors (C11, C21, C31), where the first input of the module is connected to the first terminal of the first capacitor (C11), the second input of the module is connected to the anode of a first diode (D11), which cathode is connected to the second terminal of the first capacitor (C11) and the first terminal of the second capacitor (C21) and the first terminal of the second inductor (L21), and the second terminal of the second inductor (L21) is connected to the first terminal of the bi-directional switch (T11) and simultaneously to the cathode of a third diode (DT1) and to the first terminal of the third capacitor (C31), whereby this connection point also creates the second output of the module (1), the second terminal of
the third capacitor (C31) is connected simultaneously to the first terminal of the third inductor (L31) and to the anode of a second diode (D21) creating the first output of the module (1), the second terminal of the third inductor (L31) is connected to the anode of the third diode (DT1) and to the second terminal of the bi-directional switch (T11) and to the second terminal of the second capacitor (C21), the cathode of the second diode (D21) is connected with the first terminal of the first inductor (L11), the second terminal of the first inductor (L11) is connected to the first terminal of the first capacitor (C11),the secondary side of a transformer (Tr2) is connected between the first and second inputs of the module (1) where the primary transformer side (Tr1) is put within a pulse shaping circuitry (UKI).

2. Generator setup according to claim 1, **characterized by** first output of the module (1) is connected to the first terminal of the non-linear choke (Lk), which second terminal is connected to the first terminal of the load (R), and the second terminal of the load (R) is connected to the grounded terminal where also one of the terminals of the secondary transformer side (Tr2) is connected as well as the second terminal of the first inductor (L11) and the first terminal of the of the first capacitor (C11).

3. Generator setup according to claim 1, **characterized in that** as the bi-directional switch a power transistor with anti-parallel diode is used.

4. Generator setup according to claim 1, **characterized in that** the second and third inductors (L21) and (L31) are magnetically coupled.

5. Generator setup according to any of the claims 1-4, **characterized in that** the first output of the previous module is connected to the first input of the following module and the second output of the previous module is connected to the second input of the following module.

## Patentansprüche

1. Hochspannungsimpulsgenerator-Aufbau, der als mindestens ein Modul mit Kondensatoren, Induktoren und einem bidirektionalen Schalter ausgebildet ist, **dadurch gekennzeichnet, dass** der Modul (1) drei Kondensatoren (C11, C12, C13) umfasst, wobei der erste Eingang des Moduls an der ersten Klemme des ersten Kondensators (C11) angeschlossen ist, der zweite Eingang des Moduls an der Anode der ersten Diode (D11) angeschlossen ist, deren Kathode an der zweiten Klemme des ersten Kondensators (C11) und der ersten Klemme des zweiten Kondensators (C21) und der ersten Klemme des zweiten Induktors (L21) angeschlossen ist, und die zweite Klemme des zweiten Induktors (L21) an der ersten Klemme des bidirektionalen Schalters (T11) und gleichzeitig an der Kathode einer dritten Diode (DT1) und an der ersten Klemme des dritten Kondensators (C31) angeschlossen ist, wobei dieser Anschlusspunkt auch den zweiten Ausgang des Modules (1) bildet, die zweite Klemme des dritten Kondensators (C31) gleichzeitig an der ersten Klemme des dritten Induktors (L31) und an der Anode einer zweiten Diode (D21), die den ersten Ausgang des Moduls (1) bildet, angeschlossen ist, die zweite Klemme des dritten Induktors (L31) an der Anode der dritten Diode (DT1) und an der zweiten Klemme des bidirektionalen Schalters (T11) und an der zweiten Klemme des zweiten Kondensators (C21) angeschlossen ist, die Kathode der zweiten Diode (D21) an der ersten Klemme des ersten Induktors (L11) angeschlossen ist, die zweite Klemme des ersten Induktors (L11) an der ersten Klemme des ersten Kondensators (C11) angeschlossen ist, die Sekundärseite eines Transformators (Tr2) zwischen dem ersten und dem zweiten Ausgang des Moduls (1) angeschlossen ist, wobei die Primärseite des Transformators (Tr1) sich innerhalb eines Impulsformungs-Schaltkreises (UKI) befindet.

2. Generator-Aufbau nach Anspruch 1, **dadurch gekennzeichnet, dass** der erste Ausgang des Moduls (1) an der ersten Klemme der nichtlinearen Drossel (Lk) angeschlossen ist, deren zweite Klemme an der ersten Klemme der Last (R) angeschlossen ist, und die zweite Klemme der Last (R) an der geerdeten Klemme angeschlossen ist, wo auch eine von den Klemmen der Sekundärseite eines Transformators (Tr2) sowie die zweite Klemme des ersten Induktors (L11) und die erste Klemme des ersten Kondensators (C11) angeschlossen sind.

3. Generator-Aufbau nach Anspruch 1, **dadurch gekennzeichnet, dass** ein Leistungstransistor mit einer antiparallelen Diode als der bidirektionale Schalter eingesetzt wird.

4. Generator-Aufbau nach Anspruch 1, **dadurch gekennzeichnet, dass** der zweite (L21) und der dritte Induktor (L31) magnetisch gekoppelt sind.

5. Generator-Aufbau nach einem der Ansprüche 1-4, **dadurch gekennzeichnet, dass** der erste Ausgang des vorhergehenden Moduls am ersten Eingang des nachfolgenden Moduls angeschlossen ist, und der zweite Ausgang des vorhergehenden Moduls am zweiten Eingang des nachfolgenden Moduls angeschlossen ist.

## Revendications

1. Le circuit générateur d'impulsions de haute tension composé au moins d'un module, les condensateurs, les inducteurs et un interrupteur bidirectionnel inclus, **caractérisé en ce que** le module (1) comprend trois condensateurs (C11, C21, C31), où la première entrée du module est connectée à la première borne du premier condensateur (C11), la seconde entrée du module est connectée à l'anode de la première diode (D11), dont la cathode est connectée à la seconde borne du premier condensateur (C11) et à la première borne du second condensateur (C21) et la première borne du second inducteur (L21), tandis que la seconde borne du second inducteur (L21) est connectée à la première borne de l'interrupteur bidirectionnel (T11) et, simultanément, elle est connectée à la cathode de la troisième diode (DT1) ainsi qu'à la première borne du troisième condensateur (C31), grâce à ce que ce point de connexion crée également une seconde sortie du module (1), la seconde borne du troisième condensateur (C31) est connectée simultanément à la première borne du troisième inducteur (L31) et à l'anode de la seconde diode (D21) en créant la première sortie du module (1), la seconde borne du troisième inducteur (L31) est connectée à l'anode de la troisième diode (DT1) et à la seconde borne de l'interrupteur bidirectionnel (T11) ainsi qu'à la seconde borne du second condensateur (C21), la cathode de la seconde diode (D21) est connectée à la première borne du premier inducteur (L11), la seconde borne du premier inducteur (L11) est connectée à la première borne du premier condensateur (C11), le côté secondaire du transformateur (Tr2) est connecté entre la première et le seconde entrée du module (1), où le côté primaire du transformateur (Tr1) est mis dans le système de circuits qui met en forme les impulsions (UK1).

2. Le circuit générateur, selon la révendication 1, **caractérisé en ce que** la première sortie du module (1) est connectée à la première borne de l'étrangleur non linéaire (Lk) dont la seconde borne est connectée à la première borne du récepteur (R) et la seconde borne du récepteur (R) est connectée à la borne mise à la terre où l'une des bornes du côté secondaire du transformateur (Tr2) est également connectée, de même que la seconde borne du premier inducteur (L11) et la première borne du premier condensateur (C11).

3. Le circuit générateur, selon la révendication 1, **caractérisé en ce qu'**un interrupteur bidirectionnel et un transistor de puissance y sont utilisés.

4. Le circuit générateur, selon la révendication 1, **caractérisé en ce que** le second et le troisième inducteur (L21) et (L31) sont magnétiquement couplés.

5. Le circuit générateur, selon une révendication de 1 à 4, **caractérisé en ce que** la première sortie du module précédent est connectée à la première entrée du module suivant, et la seconde sortie du module précédent est connectée à la seconde entrée du module suivant.
